# EUROPEAN PATENT APPLICATION

(11) **EP 1 676 672 A1**
(43) Date of publication of application: **05.07.2006**
(21) Application number: 04720206.4
(22) Date of filing: 12.03.2004
(51) Int. Cl.: B24B 37/04, H01L 21/304

(54) **WAFER-RETAINING CARRIER, DOUBLE SIDE-GRINDING DEVICE USING THE SAME, AND DOUBLE SIDE-GRINDING METHOD FOR WAFER**

(30) Priority: 20.03.2003 JP 2003077272
(71) Applicant: Shin-Etsu Handotai Co., Ltd, Tokyo 100-0005 (JP)
(72) Inventor: Ueno, J., Shirakawa R&D Center, Shin-Etsu Handotai, Nishishirakawa-gun, Fukushima 9618061 (JP)
(74) Representative: Cooper, John
(86) International application number: PCT/JP2004/003335
(87) International publication number: WO 2004/082890

(57) **Abstract**

The present invention is a wafer-holding carrier 1 wherein the carrier has polishing agent-passing holes 3, 4 for passing the polishing agent through as well as wafer-holding holes 2 for containing and holding wafers, and the total area of the polishing agent-passing holes occupies 15% or more of a main surface of the carrier. Preferably, the total area of the polishing agent-passing holes occupies 30% or less of the main surface of the carrier, and each of the polishing agent-passing holes has a circular shape of a diameter of 5 mm - 30 mm, and the holes are arranged in the form of concentric circle or lattice on the carrier entirely. Thereby, there can be provided an art that even when performing polishing by using a hard polishing pad in a double-side polishing apparatus, particularly, a double-side polishing apparatus having a carrier moving circularly without rotation, it is not necessary to reform the apparatus largely, and the wafer of high flatness can be finished without a tapered shape, peripheral sag, and such.

## Description

### Technical Field

The present invention mainly relates to a wafer-holding carrier that is used when polishing both sides of a wafer such as a silicon wafer, and also further relates to a double-side polishing apparatus and a double-side polishing method.

### Background Art

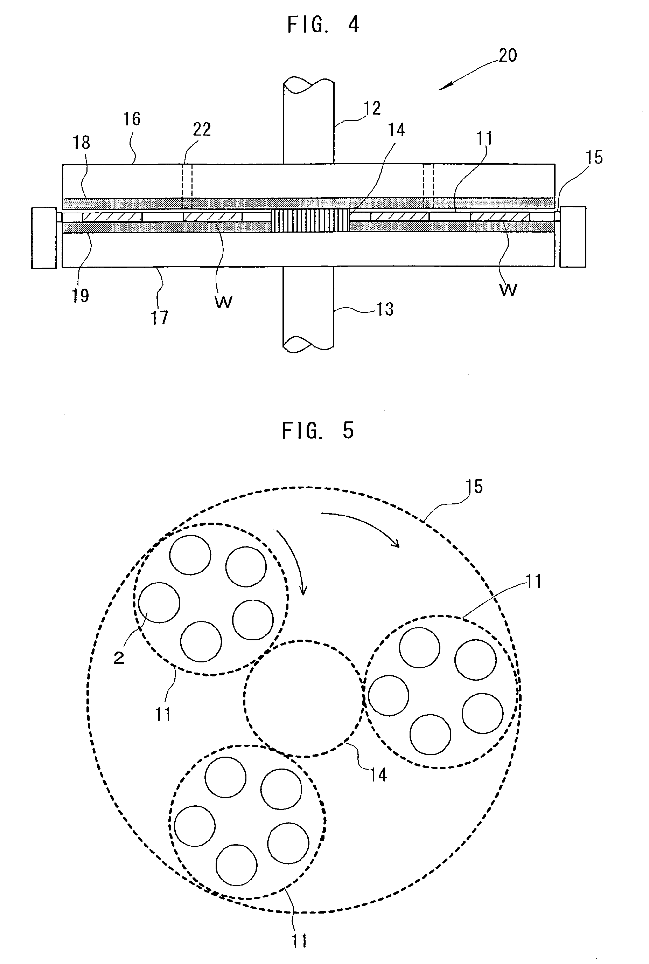

Conventionally, an apparatus 20 where a planetary gear mechanism as shown in Fig. 4 is used has been known as a polishing apparatus that polishes both sides of a silicon wafer at the same time. The polishing apparatus 20 has an upper turn table 16 and a lower turn table 17 to which polishing pads 18, 19 are attached respectively, a turn table-moving mechanism (rotation axes 12, 13) for moving the upper turn table 16 and the lower turn table 17 relatively, a wafer-holding carrier 11 for holding a wafer W between the upper turn table 16 and the lower turn table 17, a carrier-moving mechanism (an external gear 14, an internal gear 15) for moving the carrier 11 between the upper turn table 16 and the lower turn table 17, and so on.

The upper turn table 16 and the lower turn table 17 are rotated in a prescribed direction by rotation axes 12, 13 respectively. And, the upper turn table 16 is provided with holes passing through in the vertical direction (polishing agent-supplying hole) 22 so as to supply a polishing agent from above through the polishing agent-supplying holes 22 by pumping power and gravity (natural drop).

As shown in Fig. 5, plurality of the carrier 11 are set between the internal gear 15 and the external gear (sun gear) 14, and these carriers 11 intermesh with the internal gear 15 and the external gear 14 to rotate between the upper and lower turn tables 16, 17 (polishing pads 18, 19). The double-side polishing apparatus 20 as above has been called four-way (driving) system because the upper turn table 16 and the lower turn table 17 are rotated and the carriers 11 revolve with rotating.

When polishing a wafer W by using the double-side polishing apparatus 20, after containing a wafer W in each of the wafer-holding holes 2 of the carrier 11, the wafer W is sandwiched between the upper and lower turn tables 16, 17, and the carrier 11 is rotated while supplying a liquid polishing agent (also called slurry) containing abrasive grains and such. Slurry made by dispersing abrasive grains such as colloidal silica in an alkaline solution is generally used as a polishing agent when polishing a silicon wafer. The polishing agent supplied from the upper turn table side is also supplied to the lower side of the wafer W (the lower turn table side) from between the carriers 11, and both front and back surfaces of the wafer W are polished to be mirror-surface.

If a wafer W is polished by the double-side polishing apparatus 20, because both surfaces of the wafer W are polished at the same time, polishing efficiency can be improved compared to polishing by using a so-called single-side apparatus.

However, with respect to the double-side polishing apparatus 20 where a planetary gear mechanism is used as described above, there is a problem that it is difficult to correspond to recent enlargement of a silicon wafer. Namely, because the carrier 11 has a structure of moving between the internal gear 15 and the external gear 14, the diameter of the carrier 11 is smaller than the radius of the turn tables 16, 17. Therefore, particularly, in a case that a wafer with a large diameter (for example, 300 mm) is polished, it is necessary to enlarge the apparatus. However it is difficult to enlarge the apparatus because a complex gear mechanism is necessary. And also, a large internal gear becomes necessary. Problems of cost rise, efficiency lowering, setting space, and so on are caused when the apparatus is enlarged.

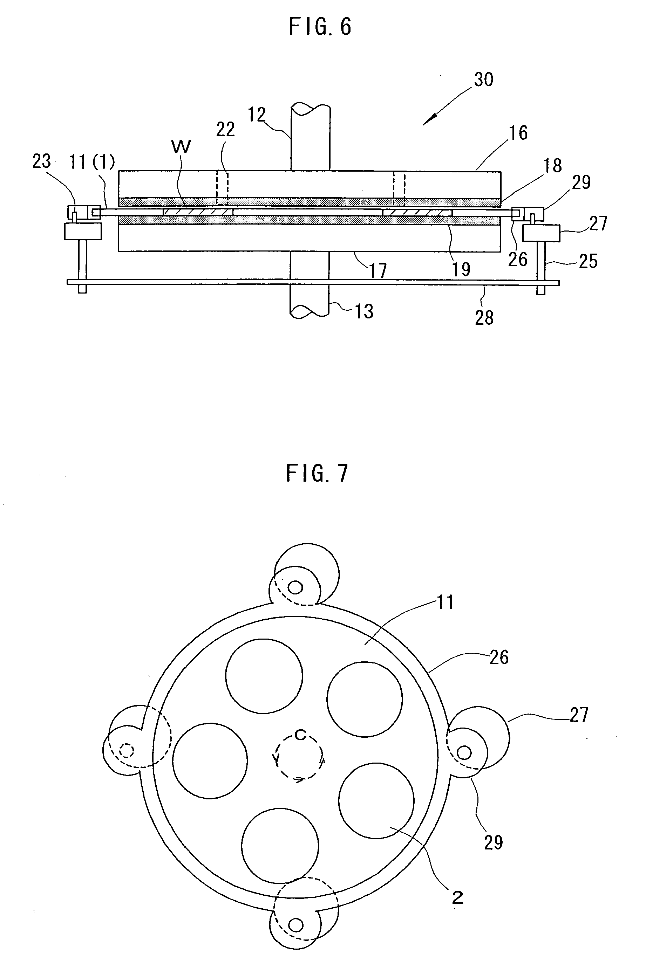

On the other hand, a downsized double-side polishing apparatus 30 has been developed as shown in Fig. 6 and Fig. 7. Because the polishing apparatus 30 performs polishing by moving the carrier 11 so as to draw a small circle without rotation in a plane through a carrier holder 26, it is not necessary to rotate the carrier around an external gear as the four-way system, and therefore it is possible to downsize the apparatus even when a wafer having a large diameter is polished (See, Japanese Patent Laid-open (Kokai) Publication No. 10-202511).

However, because the carrier 11 becomes a form so as to cover the lower turn table 17 wholly in the polishing apparatus 30, there is a problem that when slurry is supplied from the upper turn table side, the slurry stays on the upper side of the carrier 11 not to be supplied to the polishing pad 19 in the lower side sufficiently. If a polishing agent is not sufficiently supplied to the lower turn table side, rotation of the wafer in a holding hole is prevented. Therefore, a wafer shape becomes a tapered shape, or so-called peripheral sag is generated by accumulation of heat due to friction between the polishing pad 19 and the carrier 11 or the wafer W. Therefore, the wafer cannot be finished to have high flatness.

Accordingly, in order to promote supply of a polishing agent to the lower turn table side, it has been suggested that a carrier 11 is provided with several holes for passing a polishing agent therethrough, and also an apparatus has a hole in the center of a lower turn table 17 so as to force a polishing agent to discharge therefrom (See, Japanese Patent Laid-open (Kokai) Publication No. 2000-42912). However, there are problems that even if the carrier is provided with several holes, the wafer cannot be finished to have high flatness, and in the apparatus provided with the hole in the lower turn table, it is necessary to reconstruct a turn table largely which is generally used conventionally, and therefore cost rise, complicating of apparatus, and so on, are caused.

On the other hand, with respect to polishing pad, a hard polishing pad that rubber or such is a main component has been used in the recent years so as to polish a wafer to higher flatness. If the hard polishing pad is used in a single-side polishing apparatus, it is possible to polish the wafer to high flatness. However, there is a problem that if the hard polishing pad is used in a double-side polishing apparatus, because slurry is difficult to penetrate to the polishing pad and slurry-holding force is weak, the wafer shape becomes a tapered shape, or the wafer periphery is excessively polished to generate peripheral sag, and therefore sufficient flatness cannot be achieved.

Therefore, particularly, in a downsized polishing apparatus as shown in Fig. 6 and Fig. 7, it was extremely difficult to easily put double-side polishing by using a hard polishing pad into practical use.

### Disclosure of the Invention

Accordingly, the present invention was conceived in view of the above problems. An object of the present invention is to provide an art that even when performing polishing by using a hard polishing pad in a double-side polishing apparatus, particularly, a double-side polishing apparatus having a carrier moving circularly without rotation, it is not necessary to reform the apparatus largely, and the wafer of high flatness can be finished without a tapered shape, peripheral sag, and such.

In order to accomplish the above object, according to the present invention, there is provided a wafer-holding carrier which is used when holding wafers between an upper turn table and a lower turn table to which polishing pads are attached, and polishing both sides of the wafers by a polishing agent, wherein the carrier has polishing agent-passing holes for passing the polishing agent through as well as wafer-holding holes for containing and holding the wafers, and the total area of the polishing agent-passing holes occupies 15% or more of a main surface of the carrier.

If the total area of the polishing agent-passing holes occupied in a main surface of the carrier (hereinafter, also simply called, "occupied area") is 15% or more as described above, even when the carrier is used in what type of a double-side polishing apparatus, sufficient slurry comes to the lower turn table side through the polishing agent-passing holes from the upper turn table side to suppress generation of heat in the process. Further, movement of the wafer in the holding hole becomes smooth, and therefore the wafer can be finished to high flatness without generating a tapered shape of the wafer, peripheral sag, and such.

Moreover, because, by using the above-described carrier, it is not necessary to reconstruct parts except carrier of the apparatus, the carrier can be easily applied to a double-side polishing apparatus used conventionally.

In this case, it is preferable that the total area of the polishing agent-passing holes occupies 30% or less of the main surface of the carrier.

If the occupied area of the polishing agent-passing holes is 30% or less, formation of the wafer-holding hole may not be affected and strength as a carrier can be assured sufficiently.

Each of the polishing agent-passing holes preferably has a circular shape of a diameter of 5 mm - 30 mm.

If each of the polishing agent-passing holes has the above-described size, because many polishing agent-passing holes come to be formed so as to disperse in the carrier entirely, the carrier can suppress lowering of the carrier strength and pass the polishing agent all over the carrier through many polishing agent-passing holes.

It is preferable that the polishing agent-passing holes are arranged in the form of concentric circle or lattice on the carrier entirely.

If the polishing agent-passing holes are regularly arranged on the carrier entirely as described above, flow of polishing agent is more equalized all over the carrier, and therefore the carrier enables more uniform polishing.

Also, in the present invention, there is provided a double-side polishing apparatus having at least an upper turn table and a lower turn table to which polishing pads are attached, a turn table-moving mechanism for moving the upper turn table and the lower turn table relatively, a carrier for holding wafers between the upper turn table and the lower turn table, and a carrier-moving mechanism for moving the carrier between the upper turn table and the lower turn table, wherein the upper turn table is provided with a polishing agent-supplying hole for supplying a polishing agent, and the carrier is the wafer-holding carrier according to the present invention as described above.

If a double-side polishing apparatus has the carrier according to the present invention as described above, during polishing, the polishing agent supplied from the upper turn table side can sufficiently ensure flow of polishing agent through polishing agent-passing holes of the carrier to the lower turn table side. And the polishing agent is thoroughly supplied all over between lower surface of the wafer and polishing pad of the lower turn table side. Therefore, if double-side polishing of the wafer is performed by using the double-side polishing apparatus, it is possible to finish the wafer so as to have high flatness without generating a tapered shape, peripheral sag, and such. Moreover, because it is not necessary to reconstruct parts except the carrier, the apparatus becomes inexpensive.

Also, in this case, the carrier-moving mechanism may move the wafer-holding carrier circularly without rotation in a plane of the carrier to revolve the wafers held in the wafer-holding holes and between the upper turn table and the lower turn table.

In the double-polishing apparatus having the constitution as described above, the carrier becomes such a form as covers the entire plane of the lower turn table. However if the apparatus has the carrier according to the present invention, the polishing agent supplied from the upper turn table can sufficiently flow through the polishing agent-passing holes of the carrier to the lower turn table side. Therefore, it becomes possible to finish a wafer of a large diameter to have high flatness by a compact polishing apparatus.

Hardness of the polishing pad may be Shore A 50 or more, or material of the polishing pad may be urethane or rubber.

Because it was difficult that a hard polishing pad or a polishing pad of urethane or rubber was penetrated by a polishing agent, it was difficult to use the polishing pad in the double-side polishing apparatus. However, if the apparatus has the carrier according to the present invention, because a polishing agent is sufficiently supplied also to the polishing pad of in the lower turn table side, the slurry holding-force can be supplemented in the polishing pad, and it becomes possible to finish a wafer to have high flatness even if the above-described hard polishing pad is used.

Further, according to the present invention, there is provided a method for polishing both sides of wafers comprising using the double-side polishing apparatus having the carrier according to the above-described present invention, containing the wafers in the wafer-holding holes of the carrier arranged between the upper turn table and the lower turn table, moving the upper turn table and the lower turn table relatively while supplying polishing agent from the upper turn table side, and moving the carrier between the upper turn table and the lower turn table, thereby to polish the both sides of the wafers.

If double-side polishing of wafer is performed by using the double-side polishing apparatus having the carrier according to the present invention, the polishing agent is thoroughly supplied between lower surface of the wafer and polishing pad of the lower turn table side, it is possible to finish the wafer so as to have high flatness without causing a tapered shape, peripheral sag, and such.

In this case, it is preferable that amount of the polishing agent supplied from the upper turn table side is from 3 liters/min to 10 liters/min.

If the amount of the supplied polishing agent is within the range as described above, the polishing agent can be sufficiently supplied to the polishing pads attached to the upper and lower turn tables, and the wafer can be finished to have high flatness. And also, because the polishing agent is not wasted, it is economical.

Because the wafer holding-carrier of the present invention is that the total area of the polishing agent-passing holes occupies 15% or more of a main surface of the carrier, when the carrier is used in a double-side polishing apparatus, flow of the polishing agent through the polishing agent-passing holes to the lower turn table side is sufficiently ensured. Therefore, particularly by applying the carrier together with a hard polishing pad to a double-side polishing apparatus having the carrier moving circularly without rotation, it is possible to finish a wafer to high flatness without generating a tapered shape of the wafer, peripheral sag, and such.

And, because it is not necessary to reconstruct parts except the carrier, for example, the upper and lower turn tables, the carrier can be easily applied to a double-side polishing apparatus used conventionally, and cost can be held down.

### Brief Explanation of the Drawings

Fig. 1 is a plan view showing an example of the wafer-holding carrier according to the present invention.
Fig. 2 is a plan view showing an example of the conventional wafer-holding carrier.
Fig. 3 (a) is a plan view of a carrier used in Example 2.
Fig. 3(b) is a plan view of a carrier used in Comparative Example 2.
Fig. 4 is a schematic view showing an example of a four-way double-side polishing apparatus.
Fig. 5 is a schematic plan view showing a planetary gear construction.
Fig. 6 is a schematic view of a type of a double-side polishing apparatus where a carrier doesn't rotate.
Fig. 7 is a schematic plan view of a double-side polishing apparatus of Fig. 6.

### Best Mode for Carrying out the Invention

Hereinafter, the present invention will be explained in detail.

The present inventor made diligent study and search in respect of the cause that when a wafer was polished by using a double-side polishing apparatus, the wafer became a tapered shape or peripheral sag was generated. As a result, it was found that because a polishing agent could not be supplied sufficiently to a polishing pad of the lower turn table side, movement such as rotation of the wafer in a wafer-holding hole was not performed smoothly, and therefore the wafer became a tapered shape, and because slurry rising in temperature stayed, sag of wafer peripheral portion was generated, and therefore high flatness was not accomplished.

Further, the present inventor searched to find that when using particularly, a hard polishing pad or a polishing pad where urethane or rubber was a main component, force of holding a polishing agent by the polishing pad was weak and rotation of the wafer was difficult. And the present inventor found that slurry was concentrated in a narrow gap between the wafer-holding hole of the carrier and the wafer, thereby to enhance etching effect in the wafer periphery, and the wafer periphery was excessively polished to easily cause peripheral sag.

Accordingly, the present inventor found that when wafer polishing was performed by changing an occupied area, arrangement pattern, and such, variously, flatness of the wafer could be remarkably improved without reconstructing the apparatus largely by using a carrier where an occupied area of the polishing agent-passing holes was 15% or more. And therefore, the present inventors came to complete the present invention.

Hereinafter, with reference to figures, there will be described concretely the wafer-holding carrier according to the present invention and the case that a silicon wafer is polished for its both sides by using a double-side polishing apparatus having the carrier.

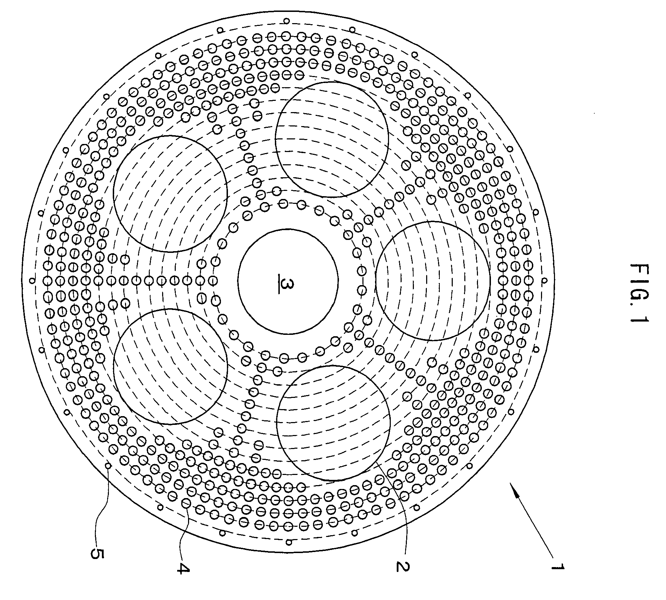

Fig. 1 shows an example of the wafer-holding carrier according to the present invention. The carrier 1 is that circular wafer holding-holes 2 for containing and holding a wafer are formed in five places. Each of the wafer holding-holes 2 is formed to have such a size that the wafer can be rotated in the wafer holding-hole 2. Further, many polishing agent-passing holes 3, 4 for passing a polishing agent through are formed as well as wafer-holding holes 2 in the carrier 1.

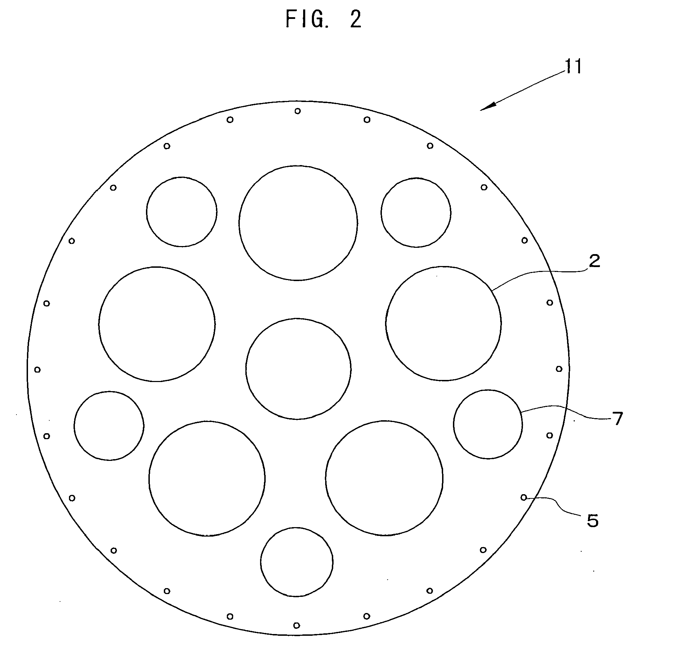

A conventional carrier is also provided with the holes for passing a polishing agent through, and however, for example, as shown in Fig. 2, comparatively large holes 7 are merely provided in several places, the total area of the holes was at most about 10 % of a main surface of the carrier 11 with a view to ensuring strength of carrier 11 in itself. On the other hand, the carrier 1 according to the present invention as shown in Fig. 1 is formed so that the total area of the polishing agent-passing holes 3, 4 occupies 15% or more of a main surface of the carrier 1.

Size and arrangement of the polishing agent-passing holes 3, 4 are not particularly limited, however if the circular polishing agent-passing holes 4 each having a diameter of 5 mm - 30 mm are arranged in the form of concentric circles as shown in Fig. 1, the polishing agent can be passed through almost equally and thoroughly all over the carrier 1, and strength as a carrier can be maintained sufficiently. In addition, if the polishing agent-passing holes 4 are arranged, for example, in the form of lattice on the carrier 1 entirely, the holes are formed almost equally and thoroughly all over the carrier, and strength can be maintained sufficiently. Also, the polishing agent-passing holes 4 may be formed in a radial pattern.

Material, size, thickness and such of the carrier 1 are dependent on a used apparatus and a size of a wafer to be polished, however for example, a glass epoxy plate having a thickness of about 700 - 900 µm can be used. For providing the glass epoxy plate with polishing agent-passing holes 4, after forming holes 4 by a driller, the processed portion is preferably chamfered.

For example, because, as a carrier for polishing a wafer having a diameter of 300 mm, one having a diameter of about 1190 mm is used generally, an occupied area of the polishing agent-passing holes 3,4 can be 15% or more of a main surface of the carrier 1 by providing one hole 3 having a diameter of 200 mm in the center of the carrier and about 540 holes 4 having a diameter of about 18 mm on the periphery entirely as shown in Fig. 1.

However, if the area of the polishing agent-passing holes 3,4 occupies more than 30% of a main surface of the carrier 1, the formation of wafer-holding holes 2 would be affected, and further there is a possibility that strength of the carrier in itself is lowered because the total area of holes, including wafer-holding holes and such, formed in the carrier would become more than 50% of a main surface of the carrier. The carrier would not be broken during polishing but would be easy to be broken when setting the carrier, handling and such. Therefore, it is preferable that the total area of the polishing agent-passing holes occupies 30% or less of the main surface of the carrier.

For example, if a carrier has a diameter of about 1190 mm as described above, the occupied area of polishing agent-passing holes can be controlled to be 30% or less even when the carrier is provided with one hole having a diameter of 200 mm in the center of the carrier and 520 holes having a diameter of about 27 mm.

In addition, in the carrier 1 of Fig.1, connecting holes 5 are also formed for fixing it to a carrier holder as described later, however they are occasionally needless depending on the shape of the apparatus.

Next, the case will be described that the carrier 1 according to the present invention is set to a double-side polishing apparatus 30 as shown in Fig.6 and Fig.7, thereby to polish a silicon wafer.

The double-side polishing apparatus 30 has an upper turn table 16 and a lower turn table 17 to which polishing pads 18, 19 are attached, a turn table-moving mechanism comprising a rotation motor, rotation axes 12, 13, and such, the wafer-holding carrier 1 for holding a wafer W between the upper turn table 16 and the lower turn table 17, a carrier-moving mechanism consisting of a carrier holder 26, eccentric arms 27, a timing chain 28, and such, and so on.

The upper turn table 16 and the lower turn table 17 are constituted so as to rotate in the prescribed directions respectively through each of rotation axes 12, 13 rotated by the rotation motor.

The upper turn table 16 is provide with polishing agent-supplying holes 22 for supplying a polishing agent. The polishing agent-supplying holes 22 are not particularly limited in terms of the shape and the number, but may be properly provided so as to supply slurry between polishing pad 18 of the upper turn table 16 and carrier 1 sufficiently and equally. For example, the polishing agent-supplying holes 22 may be arranged in the form of lengthwise and crosswise lattice or concentric circle so as to range at an equal density in the upper turn table 16. A tube and such are linked to the upper end of each of the polishing agent-supplying holes 22, and polishing agent can be supplied to the upper turn table 16 entirely from each of the polishing agent-supplying holes 22 by polishing agent-reserving means such as a slurry-reserving tank and a pump.

Material and such of polishing pads 18, 19 are not particularly limited, however, for example, it is possible to use a hard polishing pad of which hardness is Shore A 50 or more (Shore D 10 or more), particularly even a hard polishing pad of which a main component is material of urethane or rubber. Particularly, polishing pad of which hardness is Shore A 80 or more (Shore D 30 or more) is preferable, and such a polishing pad enables easily to produce a highly flat wafer required in these years. Shore A is a specification standardized by JIS K 6253 and such, and shows a value obtained by durometer type A. A particularly hard polishing pad is occasionally expressed as Shore D (a value obtained by durometer type D). Shore A 50 corresponds to about Shore D 10, and Shore A 80 to about Shore D 30.

The upper limitation of the polishing pad hardness is not limited if the desired wafer flatness can be achieved. Even if a very hard polishing pad of which hardness is about 80 of Shore D, by using the carrier according to the present invention, slurry supply and wafer movement become smooth. A tapered shape of the wafer, peripheral sag, and such, are reduced so as to finish the wafer of high flatness. It is conventionally difficult to use the above-described hard polishing pad to a double-side polishing apparatus for reasons such as a low slurry-holding force. However, the hard polishing pad can be used with the carrier 1 according to the present invention at the same time appropriately.

The carrier 1 can be moved between the upper turn table and the lower turn table by the carrier-moving mechanism comprising the carrier holder 26, eccentric arms 27, timing chain 28, and so on. The carrier 1 is fixed to the carrier holder 26 by the intermediary of connecting holes 5 provided in the periphery and pin (not shown) provided in the carrier holder 26. In the periphery of the holder 26, four bearings 29 outstanding laterally are provided at even intervals. The eccentric arm 27 is inserted into each of the bearings 29 so as to rotate freely. A rotation axis 25 is fixed in the center of the lower plane of each of the eccentric arms 27. A sprocket provided in the rotation axis 25 of each of the eccentric arms 27 is rotated by the timing chain 28, thereby to synchronize all of the eccentric arms 27 to rotate around rotation axis 25 in a horizontal plane.

By such a structure, the eccentric arm 27 acts as a crank mechanism, and the carrier 1 held by the carrier holder 26 is revolved by circular motion without rotation in a plane. The radius of the revolution (the circular movement without rotation) is the same as the interval between the axis 23 of the holder 26 side and the rotation axis 25 (distance of eccentricity), and there is caused a movement that all points of the carrier 1 draw a small circle track having the same size as shown by C in Fig. 7.

In the double-side polishing apparatus 30 having such a constitution, the carrier 1 covers the under turn table, however, by using the carrier 1 as shown in Fig. 1, a polishing agent can sufficiently come to the lower turn table side through polishing agent-passing holes 3, 4. Moreover the apparatus 30 is that because the carrier 1 in itself moves circularly without rotation, the movement distance becomes small and a load to the carrier 1 becomes also small compared to the case of using it in an apparatus of four-way system. Therefore, even if strength of the carrier 1 in itself may be somewhat degraded by providing the carrier 1 with many polishing agent-passing holes 3, 4, the carrier 1 would not be broken during polishing.

For polishing both sides of a silicon wafer by using the double-side polishing apparatus 30, after disposing the carrier 1 between the upper turn table 16 and the lower turn table 17, a wafer W is contained in the wafer-holding hole 2. Then, the carrier 1 is sandwiched between the upper and lower turn tables 16, 17, and the upper turn table 16 and the lower turn table 17 are rotated in the reverse direction to each other while a polishing agent is supplied from the upper turn table side (polishing agent-supplying holes 22). And also, the carrier 1 is circularly moved without rotation in a plane of the carrier 1 by eccentric arms 27 and such, and thereby the wafer W is revolved between the upper turn table 16 and the lower turn table 17 in the wafer-holding hole 2.

In addition, a kind of the polishing agent may be appropriately determined depending on material of polishing pad, polishing condition, and so on. When a silicon wafer is polished, for example, alkaline solution adjusted to pH 10 - pH 11 containing colloidal silica can be used.

Moreover, amount supplied of the polishing agent may be appropriately determined by considering a size of the carrier and so on, however preferably set to be from 3 liters/min to 10 liters/min. If the amount supplied of the polishing agent is less than the above range, a wafer tends to become a tapered shape, and on the other hand, if the amount supplied is more than the above range, there is a possibility that a hydroplane phenomenon and such may be caused, and thereby the wafer cannot be polished. In a hard polishing pad that hardness of the polishing pad is Shore A 50 or more as above described, or a hard polishing pad that urethane or rubber is a main component, amount supplied of the polishing agent is preferably increased because the polishing agent is difficult to penetrate to the polishing pad. And when using a soft polishing pad such as a nonwoven cloth, the amount supplied is preferably reduced.

During polishing, a polishing agent comes between polishing pad of the upper turn table side and the upper surface of the carrier 1 through polishing agent-supplying holes 22 of the upper turn table side. And further, the polishing agent comes between polishing pad 19 of the lower turn table side and the lower surface of the carrier 1 mainly through polishing agent-passing holes 3, 4 provided on the carrier entirely. Thereby, the polishing agent is supplied sufficiently to both upper and lower sides of the wafer W to equalize the polishing condition (particularly, amount of a polishing agent) in both sides of the wafer. Moreover, cooling effect is also exerted by supplying a polishing agent sufficiently to the lower surface side of the wafer W.

By performing polishing as described above, the polishing agent is thoroughly supplied all over between the wafer W and the polishing pad 19 of the lower side through polishing agent-passing holes, and movement such as rotation of the wafer in a holding hole 2 becomes smooth. It is possible to finish the wafer to high flatness without causing a tapered shape, peripheral sag, and such.

In addition, because slurry provided on the polished surface is discharged to spill over in the peripheral direction sequentially, the slurry can be also collected and recycled by circulating it.

Hereinafter, examples of the present invention and comparative examples are explained.

### (Example 1)

A glass epoxy carrier having a diameter of 1190 mm, and a thickness of 800 µm was prepared. The carrier was that about 510 circular through-holes each having a diameter of 20 mm are formed as polishing agent-passing holes .in the form of concentric circles as shown in Fig. 1, as well as that five wafer-holding holes each having a diameter of 301 mm are formed. The area ratio of the polishing agent-passing holes occupied in the main surface of the carrier was 17.23 %.

As to polishing apparatus, a type of double-side polishing apparatus where the carrier didn't rotate as shown in Fig. 6 was used.

As to polishing pad, a polishing pad consisting of an urethane pad (a hard polishing pad of about 70 in Shore D) was attached to each of the upper turn table and the lower turn table.

And, as to polishing agent, alkaline solution adjusted to pH 10.8 - pH 11 containing colloidal silica was used and the amount supplied was set to be 6 litters/min.

According to the apparatus and the condition as described above, double-side polishing of a silicon wafer having a diameter of 300 mm was performed.

Stock removal was 16 µm in both sides, and wafer shape after polishing was checked for flatness of the wafer by using a flatness tester. The flatness was 0.12 µm in SFQRmax (exclusion of 2 mm in the periphery, size of the site : 26 mm x 33 mm).

### (Comparative example 1)

The conventionally used carrier as shown in Fig. 2 was used. The carrier was provided with five holes having a diameter of 200 mm in the center and 5 holes having a diameter of 150 mm on the periphery as through-holes for passing polishing agent therethrough, in addition to wafer holding-holes. The area occupied of these through-holes in the carrier was 10.77 %.

The constitution except the carrier was similar to the apparatus of Example 1, and also, polishing was performed under the same polishing condition as Example.

As a result of the polishing, SFQRmax (exclusion of 2 mm in the periphery) was 0.32 µm and it couldn't satisfy flatness required in these years. Particularly sag in the periphery of the wafer was found, and the value of SFQRmax was particularly worse.

### (Comparative example 2 and Example 2)

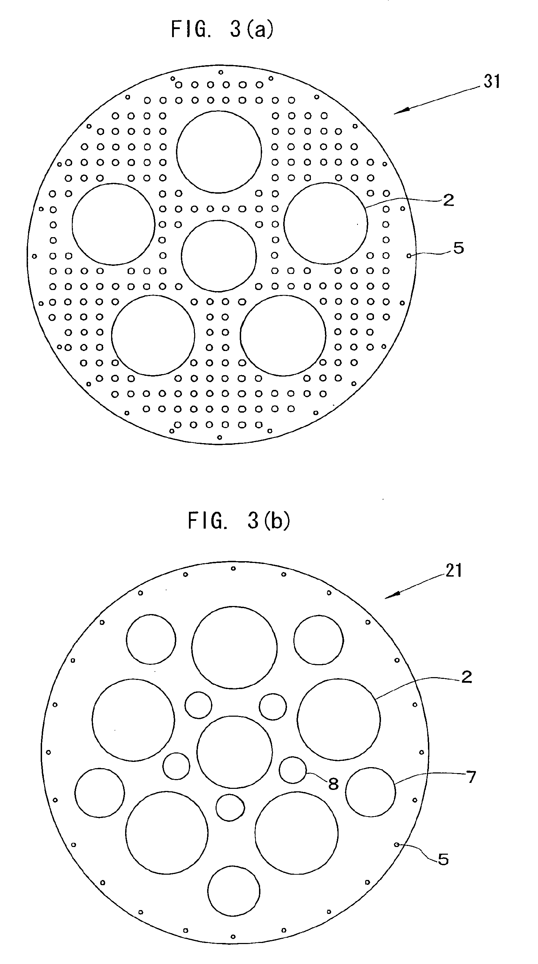

By using a carrier 21 that the occupied area ratio of polishing agent-passing holes was 14.30% (five through-holes having a diameter of 100 mm are added as shown in Fig. 3(b) ; Comparative example 2), and a carrier 31 that the ratio was 28.60 % (540 through-holes having a diameter of 26 mm in the form of lattice + one hole having a diameter of 200 mm in the center being formed as shown in Fig. 3(a) ; Example 2) respectively, polishing was performed in the same way as Example 1. Comparative example 2 resulted in SFQRmax = 0.25 µm in, and Example 2 resulted in SFQRmax = 0.11 µm.

In addition, the present invention is not limited to the embodiments described above. The above-described embodiments are merely examples, and those having the substantially same constitution as that described in the appended claims and providing the similar working effects are included in the scope of the present invention.

For example, in the above-described embodiments, the case is described that a type of a double-side polishing apparatus where the carrier is not rotated is used. The polishing apparatus isn't limited to the type, but other double-side polishing apparatus such as four-way system can be provided with the carrier of the present invention to perform polishing. And, size and arrangement of polishing agent-passing holes isn't limited to the carrier as shown in Fig. 1, but can be appropriately set depending on a polishing condition and an object to be polished as long as the total area of the polishing agent-passing holes occupies 15% or more of a main surface of the carrier.

Also, a very hard polishing pad such as Shore D 70 was used in the above Example, however, a hard polishing pad of about Shore D 30-42 (Shore A 80-90) also had a similar effect. Further, even a hard polishing pad of around Shore D 10 (about Shore A 50) could also perform polishing without generating a tapered shape, peripheral sag, and such. A further soft polishing pad is also available of course. A polishing pad may be appropriately set according to the required quality.

Thus, a polishing pad isn't particularly limited, however, by using the carrier of the present invention in a type of a double-side polishing apparatus where the carrier doesn't rotate, a hard polishing pad of which hardness is Shore A 50 or more, which was difficult to be used in a double-side polishing until now, can be preferably used. And therefore, it is vary advantageous to obtain a wafer of higher quality (higher flatness).

## Claims

1. A wafer-holding carrier which is used when holding wafers between an upper turn table and a lower turn table to which polishing pads are attached, and polishing both sides of the wafers by a polishing agent, wherein the carrier has polishing agent-passing holes for passing the polishing agent through as well as wafer-holding holes for containing and holding the wafers, and the total area of the polishing agent-passing holes occupies 15% or more of a main surface of the carrier.

2. The wafer-holding carrier according to Claim 1, wherein the total area of the polishing agent-passing holes occupies 30% or less of the main surface of the carrier.

3. The wafer-holding carrier according to Claim 1 or 2, wherein each of the polishing agent-passing holes has a circular shape of a diameter of 5 mm - 30 mm.

4. The wafer-holding carrier according to any one of Claims 1 to 3, wherein the polishing agent-passing holes are arranged in the form of concentric circle or lattice on the carrier entirely.

5. A double-side polishing apparatus having at least an upper turn table and a lower turn table to which polishing pads are attached, a turn table-moving mechanism for moving the upper turn table and the lower turn table relatively, a carrier for holding wafers between the upper turn table and the lower turn table, and a carrier-moving mechanism for moving the carrier between the upper turn table and the lower turn table, wherein the upper turn table is provided with a polishing agent-supplying hole for supplying a polishing agent, and the carrier is the wafer-holding carrier according to any one of Claims 1 to 4.

6. The double-side polishing apparatus according to Claim 5, wherein the carrier-moving mechanism moves the wafer-holding carrier circularly without rotation in a plane of the carrier to revolve the wafers held in the wafer-holding holes and between the upper turn table and the lower turn table.

7. The double-side polishing apparatus according to Claim 5 or 6, wherein hardness of the polishing pad is Shore A 50 or more.

8. The double-side polishing apparatus according to any one of Claims 5 to 7, wherein material of the polishing pad is urethane or rubber.

9. A method for polishing both sides of wafers comprising using the double-side polishing apparatus according to any one of Claims 5 to 8, containing wafers in the wafer-holding holes of the carrier arranged between the upper turn table and the lower turn table, moving the upper turn table and the lower turn table relatively while supplying a polishing agent from the upper turn table side, and moving the carrier between the upper turn table and the lower turn table, thereby to polish the both sides of the wafers.

10. The method for polishing both sides of wafers according to Claim 9, wherein amount of the polishing agent supplied from the upper turn table side is from 3 liters/min to 10 liters/min.
